# EUROPEAN PATENT APPLICATION

(11) **EP 1 852 923 A2**
(43) Date of publication of application: **07.11.2007**
(21) Application number: 07251595.0
(22) Date of filing: 13.04.2007
(51) Int. Cl.: H01L 51/44

(54) **Photosensing transistors**

(30) Priority: 03.05.2006 GB 0608730
(71) Applicant: Seiko Epson Corporation, Shinjuku-ku Tokyo 163-0811 (JP)
(72) Inventor: Kugler, Thomas, Cambridge, CB4 0FE (GB)
(74) Representative: Cloughley, Peter Andrew

(57) **Abstract**

A thin film transistor (TFT) photosensitive to illumination with light, which may enhance the transistor's characteristics and the controlling parameters of the transistor state. The transistor comprises an insulating substrate (1); a source electrode (2); a drain electrode; a semiconductor layer (4) of a first semiconductor material, which forms a channel of the transistor; a gate electrode (6); and an insulating layer (5) between the gate electrode and the semiconductor layer. A second semiconductor material (3) is disposed between and in electrical connection with the semiconductor layer and at least one of the source electrode and the drain electrode. The second semiconductor material is photoconductive.

## Description

The present invention relates to photosensitive thin film transistors (TFTs) and methods for producing them.

Organic thin film transistors (OTFTs) have gained considerable interest due to their potential application in low cost integrated circuits and large area flat panel displays. Although the highest device performance in terms of field effect mobility is observed in devices incorporating films of evaporated small molecules, research into polymer semiconductors remains at a high level of activity as they are intrinsically compatible with printing technologies in ambient conditions.

Possible applications of OTFTs include printed poly(3-hexylthiophene) (P3HT)-based printed integrated circuits, as disclosed by A. Knobloch, A. Manuelli, A. Bernds, W. Clemens, "Fully printed integrated circuits from solution processable polymers", J. Appl. Phys., vol. 96, (2004); pentacene-based OTFTs integrated with organic light-emitting devices (OLEDs), as disclosed by T.N. Jackson, Y. Lin, D.J. Gundlach, and H. Klauk, "Organic thin-film transistors for organic light-emitting flat-panel display backplanes", IEEE J. Select. Topics Quantum Electron., vol. 4, pp. 100-104 (1998); poly(3-hexylthiophene) (P3HT)-based OTFTs integrated with OLEDs, as disclosed by H. Sirringhaus, N. Tessler, and R.H. Friend, "Integrated optoelectronic devices based on conjugated polymers", Science, vol. 280, pp. 1741-1743 (1998); and poly(9,9-dioctylfluorene-co-bithiophene) (F8T2)-based OTFTs integrated with electrophoretic displays.

Another application area for organic-based devices is their use as photodetectors. Such photodetectors can be classified according to two main groups: two-terminal photodiodes and three-terminal phototransistors.

A variety of organic material-based photodiode structures has been disclosed over the last decade, including phase-separated donor-acceptor blends made from p-type conjugated polymers and acceptor moieties such as fullerene derivatives (Gao, F. Hide, and H. Wang, "Efficient photodetectors and photovoltaic cells from composites of fullerenes and conjugated polymers: Photoinduced electron transfer", Synth. Met., vol. 79, pp. 177-181 (1996)) or inorganic oxide semiconductors (K.S. Narayan and T.B. Singh, "Nanocrystalline titanium dioxide-dispersed semiconducting polymer photodetectors", Appl. Phys. Lett., vol. 74, pp. 3456-3458 (1999)).

A significant advantage of three-terminal phototransistors as compared to two-terminal photodiodes is the fact that phototransistors allow for a built-in amplification of the current signal that results from illuminating the device (that is, photon-to-current gains larger than 1 can be realised).

US 5,315,129 discloses an organic bipolar junction phototransistor structure based on alternating layers of two crystalline planar organic aromatic semiconductors that display n-type and p-type conductivity, respectively. The organic layers are deposited by organic molecular beam deposition while maintaining tight control of the layer thickness (the thickness of the n-type base layer may be as low as 10A). The photoresponse of the device relies on the creation of excitons in either the base or the collector layer. The excitons drift to the interface, dissociate, and the resulting electrons and holes are then swept across the base into the emitter and collector, respectively. The base potential barrier is modulated by the presence of photogenerated charge, which results in a modulation of the space charge current between the emitter and collector via injection from the contacts.

The base in bipolar junction phototransistors can be made to comprise thin multilayer stacks in order to increase the optical efficiency and gain, as disclosed in EP 0 638 941A. In particular, this document discloses a long wavelength phototransistor which has n-doped silicon as emitter and collector regions, bracketing a base region having a quantum well structure made up of alternating layers of p-doped silicon germanium and un-doped silicon.

Thin film transistors (TFTs) based on conjugated polymers have been implemented both as radiation detectors capable of delivering a cumulative response, and as illumination sensors with a transient response.

WO 98/05072 discloses a radiation sensor comprising a polymer-based TFT. lonising radiation causes accumulative changes of the electrical properties of the detector, and the electrical properties provide an indication of the integrated radiation dose incident upon the detector.

Several publications describe polymer-based photosensitive TFTs in which the formation of excitons occurs within the semiconductor material that forms the transistor channel. Hamilton et al. studied the influence of white-light illumination on the electrical performance of poly(9,9-dioctylfluorene-cobithiophene) (F8T2)-based TFTs (see M.C. Hamilton, S. Martin, and J. Kanicki, "Thin-Film Organic Polymer Phototransistors", IEEE TRANSACTIONS ON ELECTRON DEVICES, vol. 51, pp. 877-885 (2004)). The off-state drain current of the devices increased significantly, while a smaller relative effect was observed in the strong-accumulation regime. The illumination effectively decreased the threshold voltage of the devices and increased the apparent sub-threshold swing, while the field-effect mobility of the charge carriers in the polymer channel remained unchanged. These observations were explained in terms of the photogeneration of excitons, which subsequently diffuse and dissociate into free charge carriers, thereby enhancing the carrier density in the channel. Some of the photogenerated electrons are trapped into and neutralise positively charged states that contribute to the large negative threshold voltage observed for operation in the dark, thereby reducing the threshold voltage. The authors report broadband responsivities of approximately 0.7mA/W for devices biased in the strong-accumulation regime, and gate-to-source voltage-independent photosensitivities of approximately 10³ for devices in the off-state.

The formation of excitons upon illumination of polymer-based TFTs, and thereby the photosensitivity of the transistor, can be increased by introducing dilute quantities of electron acceptor moieties into the p-type semiconducting polymer matrix. US 6,992,322 discloses the addition to polyalkylthiophenes of dilute quantities of buckminsterfullerene, C60, or derivatives thereof, viologen, dichloro-dicyano-benzoquinone, nanoparticles of titanium dioxide, and nanoparticles of cadmium sulphide, thereby enabling electron transfer from the polymer matrix upon photoexcitation in order to obtain a high photo-induced current between the drain and source electrodes.

Alternatively, organic phototransistors can be based on asymmetrically spiro-linked compounds, where intramolecular charge transfer between a sexiphenyl/terfluorene-derivative (acceptor) and a bis(diphenylamino)biphenyl (donor) moiety leads to an increase in the charge carrier density upon UV-illumination, providing the amplification effect. This is disclosed in T.P.I Saragi, R. Pudzich, T. Fuhrmann, and J. Salbeck, "Organic phototransistor based on intramolecular charge transfer in a bifunctional spiro compound", Appl. Phys. Lett. vol. 84, pp. 2334-2336 (2004). As demonstrated by T.P.I Saragi et al., the drain off-current increases significantly upon illumination, whereas the drain current in the accumulation regime is relatively unaffected, and the charge carrier mobility remains constant. In agreement with the results presented in M.C. Hamilton, S. Martin, and J. Kanicki, "Thin-Film Organic Polymer Phototransistors", IEEE TRANSACTIONS ON ELECTRON DEVICES, vol. 51, pp. 877-885 (2004), illumination shifts the threshold voltage towards more positive gate voltages.

A disadvantage of polymer-based phototransistors that rely on the formation and dissociation of excitons in the bulk of the polymer semiconductor layer is their slow response times: switching off the light source after illumination of the phototransistor results in a decay of the drain current within a time frame ranging from seconds to tens of seconds.

A potential application area of organic phototransistors is in the field of image sensors. US 6,831,710 discloses flat panel image sensors comprising photosensitive TFTs allowing the detection of electromagnetic radiation in and near the visible light spectrum. Other applications include light-emitting matrix array displays with integrated light sensing elements, providing an electro-optical feedback control of each pixel in a simple manner, as disclosed in WO 01/99191.

It is an object of the present invention to provide thin film transistors with improved photosensitivity and fast response times.

According to the present invention, there is provided a photosensing transistor comprising: a source electrode; a drain electrode; a semiconductor layer of a first semiconductor material, which forms a channel of the transistor; a gate electrode; and an insulating layer between the gate electrode and the semiconductor layer, wherein a second semiconductor material is disposed between and in electrical connection with the semiconductor layer and at least one of the source electrode and the drain electrode, the second semiconductor material being photoconductive.

In this way, it is possible to provide a transistor having high gain, excellent photosensitivity and rapid response times. Moreover, the electrical characteristics of the transistor are easily controllable by adjusting both the ambient light and the gate voltage.

Preferably, the first and second semiconductor materials are of opposite conductivity types, wherein a p-n junction is formed at each interface between the first and second semiconductor materials. It is further preferred that the first semiconductor material is p-type and the second semiconductor material is n-type.

It is preferred that the second semiconductor material is formed between and in electrical connection with the first semiconductor layer and the source electrode. It is also preferred that the second semiconductor material is formed between and in electrical connection with the first semiconductor layer and both the source electrode and the drain electrode.

In one aspect, a thickness of the second semiconductor material is 100nm or less.

In another aspect, the first semiconductor material has a field effect mobility of 10⁻³ cm²/Vs or greater

It is preferred that the first semiconductor material is organic. One such suitable material is poly(9,9-dioctylfluorene-co-bithiophene) .

It is also preferred that the second semiconductor material is inorganic.

Advantageously, the second semiconductor material may be formed by chemical reaction of the source or drain electrode. In particular, the second semiconductor material may be formed from a reaction of the source or conductor with a Group 16 element of the periodic table.

Alternatively, the second semiconductor material may be formed by one of a wet process using (NH₄)₂S, inkjet film fabrication, or dry film fabrication.

In one aspect, the source and drain electrodes are formed with a Group 11 or a Group 12 element of the periodic table. Preferably, the source and drain electrodes are formed of at least one of Ag, Cu, Cd, Pb, Ti, Zn, Ni, Co, Mn, and Fe.

Advantageously, the second semiconductor material may then comprise at least one of Ag₂O, AgO, Ag₂S, TiO₂, ZnO, CuO, Cu₂S, CuS, NiAs, CoAs₂, MnO₂, Fe₃O₄, PbS, PbSe, CdS, and CdSe.

Preferably, the gate electrode has an optical transmission across the visible wavelength range of more than 50%; the insulating layer has an optical transmission across the visible wavelength range of more than 80%; the first semiconductor material has a light absorption coefficient of 10⁴cm⁻¹ or less for at least a portion of the visible wavelength range; and the second semiconductor material has a light absorption coefficient of more than 10⁴cm⁻¹ across the visible wavelength range.

If desired, the first semiconductor material may also be photoconductive.

In one aspect, at least one of the source and drain electrodes is formed of the second semiconductor material - that is, the photoconductive source or drain material directly contacts the first semiconductor material.

Advantageously, the transistor may further comprise a colour filter. The colour filter may formed by providing a colorant in at least one of the gate electrode and the insulating layer. Preferably, however, the colour filter comprises a separate colour layer.

According to another aspect of the present invention, there is provided an electrical device comprising a photosensing transistor as discussed above.

According to a yet further aspect of the present invention, there is provided a method for forming a photosensing device comprising: forming source and drain contacts; depositing a semiconductor layer formed of a first semiconductor material between the source and drain contacts; and providing a gate electrode positioned to cover the transistor channel, with an insulating dielectric layer between the gate electrode and the semiconductor layer, wherein at least a portion of at least one of the source and drain contacts comprises a second semiconductor material, the second semiconductor material being photoconductive.

The second semiconductor material may form a coating on the at least one of the source and drain electrodes.

In particular, the step of forming the source and drain contacts may further comprise treating the surface of the source and drain contacts to form a thin coating layer of the photoconducting semiconductor material.

The present invention will now be described by way of example only, and with reference to the accompanying drawings, in which:
Figs. 1 a and 1 b are schematic diagrams illustrating top-gate and bottom-gate configurations, respectively, of a photo-TFT structure in accordance with the present invention;
Figs. 2a and 2b are schematic diagrams illustrating the band alignment at the p-n junctions formed at the interfaces between the semiconductor coating on the source and drain contacts and the organic semiconductor layer for V_{DS} = 0V (Fig. 2a) and V_{DS} < 0V (Fig. 2b);
Fig. 3 shows the output characteristics (i.e. drain current (I_{DS}) vs. drain voltage (V_{DS})) of a photo-TFT for operation in the dark, and for illumination with a low-intensity light source, the output being displayed for gate voltages of 0V, -10V, -20V, -30V, and -40V;
Fig. 4 shows the transfer characteristics (i.e. drain current (I_{DS}) vs. gate voltage (V_{G})) of a photo-TFT for operation in the dark, for illumination with a low-intensity light source, and for illumination with a high-intensity light source, the transfer curves being displayed for device operation in the linear and the saturation range (for drain voltages (V_{DS}) of -5V and -40V, respectively);
Fig. 5 shows plots of the square root of the drain currents (I_{DS}^{-1/2}) vs. gate voltage for device operation in the saturation range for operation in the dark, under low-intensity illumination, and under high-intensity illumination;
Fig. 6 shows plots of the photosensitivity (I_{DS}, illuminated - I_{DS}, _{dark})/I_{DS}, dark VS. the gate voltage V_{G} for low-intensity and high-intensity illumination, respectively, the photosensitivity curves being displayed for device operation in the linear as well as the saturation range (for drain voltages (V_{DS}) of -5V (open triangles) and -40V (filled squares), respectively);
Fig. 7a shows the rise of the drain current I_{DS} as a function of time after switching ON an additional light source (i.e. an increase of the illumination intensity from low-intensity to high-intensity); and
Fig. 7b displays the decay of the drain current I_{DS} as a function of time after switching OFF an additional light source (i.e. a decrease of the illumination intensity from high-intensity to low-intensity).

One embodiment of the present invention is a photosensing hybrid organic/inorganic thin film transistor (PHOITFT) comprising an insulating substrate with a substrate surface, a semiconductor organic layer, an electrically conducting source electrode that is covered with a thin photoconducting semiconductor coating, said semiconductor coating being in electrical contact with the organic semiconductor layer, an electrically conducting drain electrode that is covered with a thin photoconducting semiconductor coating, said semiconductor coating being in electrical contact with the organic semiconductor layer, an insulating layer, and an optically transparent and electrically conducting gate electrode positioned adjacent to the insulating layer.

The thin photoconducting semiconductor coatings on the source contact and on the drain contact are of the opposite conductivity type as compared to the material of the organic semiconductor layer, i.e. n-type in case of a p-type organic semiconductor layer. This results in the formation of p-n junctions at the interfaces between the organic semiconductor layer and the photoconducting semiconductor coatings on the source contact and on the drain contact.

The semiconducting organic layer preferably has a field effect mobility of 10⁻³ cm²/Vs or greater, and further displays moderate to low optical absorption coefficients α ranging from 10⁴/cm to 10⁵/cm in the wavelength range of the light that is to be detected. These requirements are fulfilled in the case of poly(9,9-dioctylfluorene-co-bithiophene), as supplied by ADS, which is a preferred semiconductor layer material in the present invention.

Although it is preferred to use a organic material for the semiconducting layer from a processing point of view, any suitable material can be used.

Examples of suitable p-type semiconductor materials include:
(I) Polymers:
   - amorphous polymers based on triarylamine: Polytriarylamine (PTAA) [transparent in the visible range]
   - poly(9,9-dialkylfluorene-alt-triarylamine) (TFB)
   - poly(9,9-dioctylfluorene-alt-bithiophene) (F8T2)
   - regioregular poly(3-hexylthiophene) (P3HT) (highly light absorbing in the visible range)
   - poly[5,5'-bis(3-dodecyl-2-thienyl)-2,2'-bithiophene] (PQT-12)
(II) Small molecules:
   - pentacene
   - quaterthiopenes and sexithiophenes substituted with alkyl side chains
   - rubrene

### Examples of suitable n-type semiconductor materials include:

(I) Polymers:
   - poly(benzobisimidazobenzophenanthroline) (BBL)
(II) Small molecules:
   - diperfluorohexyl-substituted quinque- and quaterthiophenes
   - methanofullerene phenyl C61-butyric acid methyl ester (PCBM)
   - fluoroalkyl-substituted naphthalenetetracarboxylicdiimides

It should be appreciated that these examples are non-limiting.

The photoconducting semiconductor coatings on the source and drain contacts preferably display high optical absorption coefficients α ranging from 10⁵/cm to 10⁶/cm in the wavelength range of the light that is to be detected, thereby enabling efficient photoexcitation within the photoconducting semiconductor coatings, which results in a lowering of the electrostatic potential barrier at the p-n junction and a high photo-induced current between the source and drain contacts. These requirements are fulfilled in the case of silver contacts coated with thin layers of silver oxide (Ag₂O or AgO) or silver(I)sulphide (Ag₂S). Other possible contact materials include titanium, zinc, copper, nickel, cobalt, manganese, iron, lead and cadmium, with photoconductive, semiconductor coatings of titanium dioxide (TiO₂), zinc oxide (ZnO), copper oxide (CuO), copper sulphide (Cu₂S and CuS), nickel arsenide (NiAs), cobalt arsenide (CoAs₂), manganese dioxide (MnO₂) iron oxide (Fe₃O₄), lead sulphide (PbS), lead selenide (PbSe), and cadmium selenide (CdSe), all of which are known photoconductive, semiconductors.

However, the source and drain contacts may be formed of any suitable material and the photoconductive semiconductor material coating can be formed by reaction of the contacts with, for example, a Group 16 element.

It is preferred that where the semiconductor organic layer is n-type, the photoconducting semiconductor coating is p-type. It is noted that many transition metal oxides, sulphides, and selenides are n-type semiconductors (see the examples listed above). However, not all compounds are n-type: a large number of transition metal oxides and chalcogenides are p-type semiconductors. These include nickel oxide (NiO), bismuth oxide (BiO), chromium oxide (Cr₂O₃), manganese oxide (MnO), iron oxide (FeO), zinc telluride (ZnTe), cadmium telluride (CdTe), CulnSe₂, etc. Accordingly, it will be clear that a p-n junction can be formed irrespective of whether the semiconductor organic layer is p-type or n-type. Consequently, the range of suitable materials for forming the semiconductor organic layer is not limited.

As noted above, reaction of metallic contacts with a Group 16 element in elemental form can be used to produce the corresponding photoconductive, semiconducting compound. Alternatively, the compounds can be obtained:
(1) via reaction of the metals with the hydrogen compounds of the Group 16 element (e.g. by reaction of silver with H₂S),
(2) via anodic oxidation of the metal electrode in the presence of a chalcogenide anion-containing or chalcogenide anion-releasing species (e.g. electrochemical formation of Ag₂S by anodic oxidation of metallic silver in the presence of a metal sulphide or thiourea),
(3) via surface modification of the metal electrode by an oxygen- or a chalcogenide-containing plasma, and
(4) via sputter-deposition or thermal evaporation of the metal chalcogenide on top of the metal contacts.

The gate electrode is preferably partially transparent. The optical transmission across the visible range should be more than 50%, preferably more than 70%, and most preferably more than 75%. Preferably, the top gate electrode is as transparent as possible. PEDOT-PSS films display > 75% transmission in the visible range for film thicknesses below 200nm and are considered suitable for use in the present invention.

The insulating layer is at least partially transparent to illumination and is chosen to avoid intermixing at the interface to the semiconductor layer. The optical transmission across the visible range should be more than 80%, preferably more than 90%, and most preferably more than 95%. It may be comprised of a polymeric material such as polyvinylphenol (PVP). Preferably, the polymer dielectric is also as transparent as possible. Polyvinylphenol (PVP), which is preferred for use in the present invention, displays optical transmission of more than 95% for a film thickness of 600nm and is effectively transparent in the visible wavelength range.

It is also preferred that the semiconductor layer is relatively transparent and that in contrast the photoconducting semiconductor coating is highly light absorbing. In this way, the sensitivity of the device can be maximised. As noted above, a preferred semiconductor for use in the present invention is poly(9,9-dioctylfluorene-co-bithiophene), which is relatively transparent in the wavelength range above 525nm (the optical absorption coefficient α is in the order of 10⁴cm⁻¹). Below 525nm, its absorption coefficient increases by one order of magnitude to approx. 10⁵cm⁻¹.

As noted above, silver sulphide (Ag₂S) is a preferred photoconducting semiconductor coating for the present invention. Its optical absorption coefficients α in the visible region are of the order of 10⁵cm⁻¹, which implies that a film thickness 3/ α = 300nm is sufficient to absorb 95% of the radiation in this range of wavelengths. Advantageously, since silver sulphide is black, it absorbs across the whole visible range of wavelengths.

In one aspect of the present invention, photo-TFTs are combined with colour filters to produce devices that respond to preselected wavelengths only ("wavelength-sensitive photo-TFTs").

The colour filters can be realized by adding dyes to the dielectric polymer layer or the transparent gate electrode. However, in order not to interfere with the electronic functionality of the dielectric and gate electrode layer, it is preferred that the colour filters are realized as an additional layer, for example on top of the gate electrode.

In addition to the absorption coefficients, the optical density/refractive indices in the different layers will influence the device performance as a function of the layer thicknesses.

It is known to form the semiconductor layer in a transistor using a photoconductive semiconductor material. As mentioned above, these prior art semiconductor materials may comprise:
- a pure organic polymer (F8T2 in the case of M.C. Hamilton, S. Martin, and J. Kanicki, "Thin-Film Organic Polymer Phototransistors", IEEE TRANSACTIONS ON ELECTRON DEVICES, vol. 51, pp. 877-885 (2004));
- a mixture of an organic polymer and dilute quantities of electron acceptor moieties (see US 6,992,322 which discloses the addition to polyalkylthiophenes of dilute quantities of buckminsterfullerene, C60, or derivatives thereof, viologen, dichloro-dicyano-benzoquinone, nanoparticles of titanium dioxide, and nanoparticles of cadmium sulphide); and
- asymmetrically spiro-linked compounds, where intramolecular charge transfer between a sexiphenyl/terfluorene-derivative (acceptor) and a bis(diphenylamino)biphenyl (donor) moiety leads to an increase in the charge carrier density.

The spectral photosensitivity range of these devices is restricted by the optical bandgaps of the light-absorbing compounds. Poly(9,9-dioctylfluorene-cobithiophene) becomes strongly absorbing only for photon energies above 2.4eV (wavelengths below 525nm), with an optical absorption coefficient α in the order of 10⁵cm⁻¹, but is rather transparent for smaller photon energies (longer wavelengths) (the optical absorption coefficient α decreases to 10⁴cm⁻¹). The spiro-linked charge transfer compounds absorb in the ultraviolet range.

In contrast, Ag₂S possesses a direct optical band gap of 1.0eV, which makes it a very efficient absorber of radiation within and beyond the visible range into the infrared region (the optical absorption coefficients α in the visible region are of the order of 10⁵cm⁻¹, which implies that a film thickness 3/α = 300nm is sufficient to absorb 95% of the radiation in this range of wavelengths).

It should be noted that the present invention encompasses the case where the material used to form the semiconductor layer is also a photoconductive material, which is different to the material used to form the photoconductive semiconductor coating. For example, as discussed above, poly(9,9-dioctylfluorene-co-bithiophene) is a photoconductive semiconductor material.

One operational aspect of a transistor in accordance with the present invention is that the transistor drain current can be controlled both by the voltage applied to the gate electrode and by the intensity of light incident upon the transistor. Transistor saturation current gains of up to 1000 may be achieved for appropriate combinations of illumination levels and gate voltage biasing.

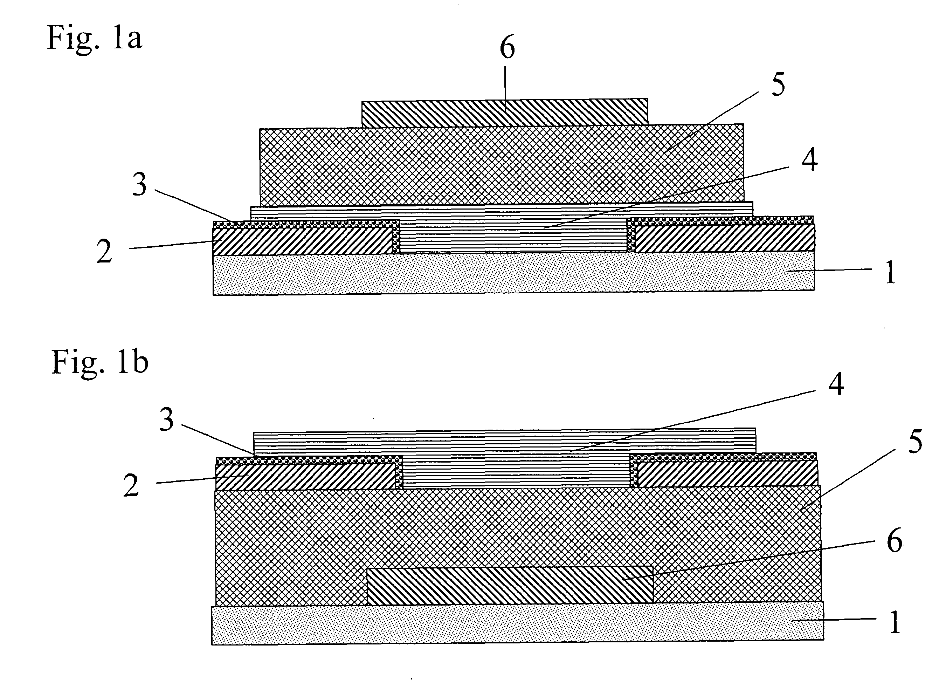

Fig. 1 a is schematic diagram illustrating a top-gate configuration of a photo-TFT structure fabricated in accordance with the present invention. The structure comprises an insulating substrate 1 with a pattern of separate, electrically conducting source and drain contacts 2. The source and drain contacts 2 are covered by a thin layer of a photoconducting semiconductor 3. The source/drain pattern is covered by a thin organic semiconductor layer 4, which fills the gap between the source and the drain contacts 2, thus forming the transistor channel. The semiconductor layer 4 is covered by an insulating dielectric layer 5, on top of which is deposited the gate electrode 6. To allow sensing of illumination from the top of the stack, both the gate electrode 6 and the dielectric layer 6 are optically transparent in the wavelength range of the light to be detected.

Fig. 1 b is a schematic diagram illustrating a bottom-gate configuration of a photo-TFT structure in accordance with the present invention. The structure comprises an insulating substrate 1 onto which the gate electrode 6 is deposited. The gate electrode 6 and the surrounding substrate areas are covered by an insulating dielectric layer 5. A pattern of separate, electrically conducting source and drain contacts 2 is defined on top of the dielectric layer 5, each overlapping with an opposite edge of the underlying gate electrode 6. The source and drain contacts 2 are covered by a thin layer of a photoconducting semiconductor 3. The source/drain pattern on top of the dielectric layer 5 is covered by a thin organic semiconductor layer 4, which fills the gap between the source and the drain contacts 2, thus forming the transistor channel.

To allow sensing of illumination from the semiconductor side (from the top of the stack), only the organic semiconductor layer has to be optically transparent in the wavelength range of the light to be detected.

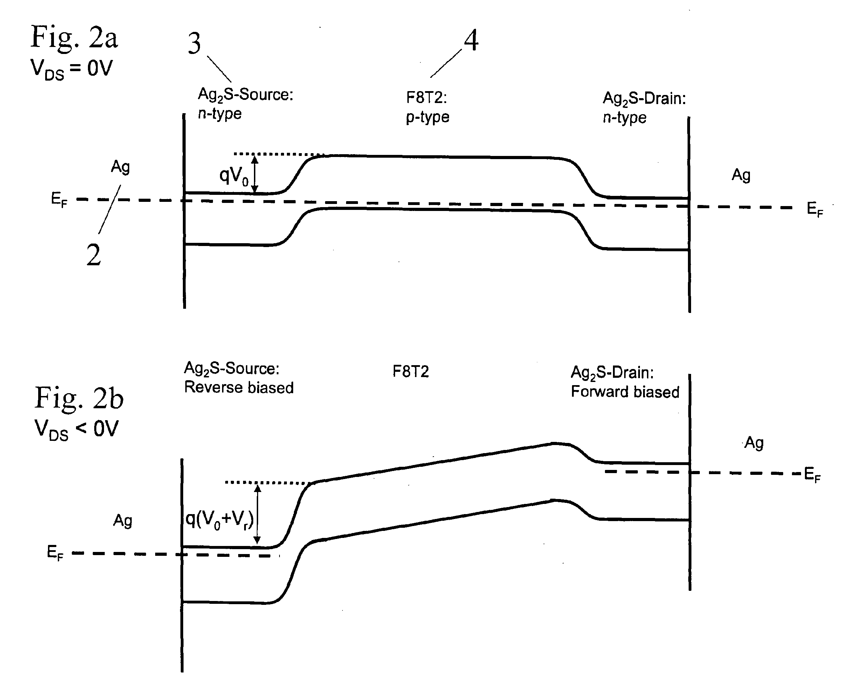

Figs. 2a and 2b are schematic diagrams illustrating the band alignment at the p-n junctions formed at the interfaces between the semiconductor coating 3 on the source and drain contacts 2 and the organic semiconductor layer 4 in transistors having a structure as shown in Figs. 1 a and 1 b. In Figs. 2a and 2b, it is assumed that the organic semiconductor layer displays p-type conductivity, as is the case for poly(9,9-dioctylfluorene-co-bithiophene). Furthermore, it is assumed that the semiconductor coating covering the source and drain contacts displays n-type conductivity, as is the case for silver sulphide (Ag₂S). For zero applied drain voltage (V_{DS} = 0V), the potential barrier height (qV₀) at the p-n junction between the source contact and the organic semiconductor layer is identical to the potential barrier height at the p-n junction between the drain contact and the organic semiconductor layer (see Fig. 2a). When a negative drain voltage is applied (V_{DS} < 0V), the p-n junction at the interface between the source contact and the organic semiconductor layer is in reverse bias, whereas the p-n junction between the drain contact and the organic semiconductor layer is in forward bias. Thus, the reverse biased p-n junction at the interface between the source contact and the organic semiconductor layer becomes the bottleneck (potential barrier: q(V₀+Vᵣ)) that limits the flow of current between the source and drain contacts (see Fig. 2b). Illumination of the reversed biased p-n junction at the source contact results in a lowering of the potential barrier and thereby an increase of the current flow between source and drain contacts.

It should be noted that it is only necessary to provide the photoconductive, semiconductor coating 3 on one of the source and drain contacts. As is evident from Fig. 2b, in the case where the transistor is reverse biased, a particularly strong effect can be achieved where the photoconductive, semiconductor coating 3 is provided only on the source contact.

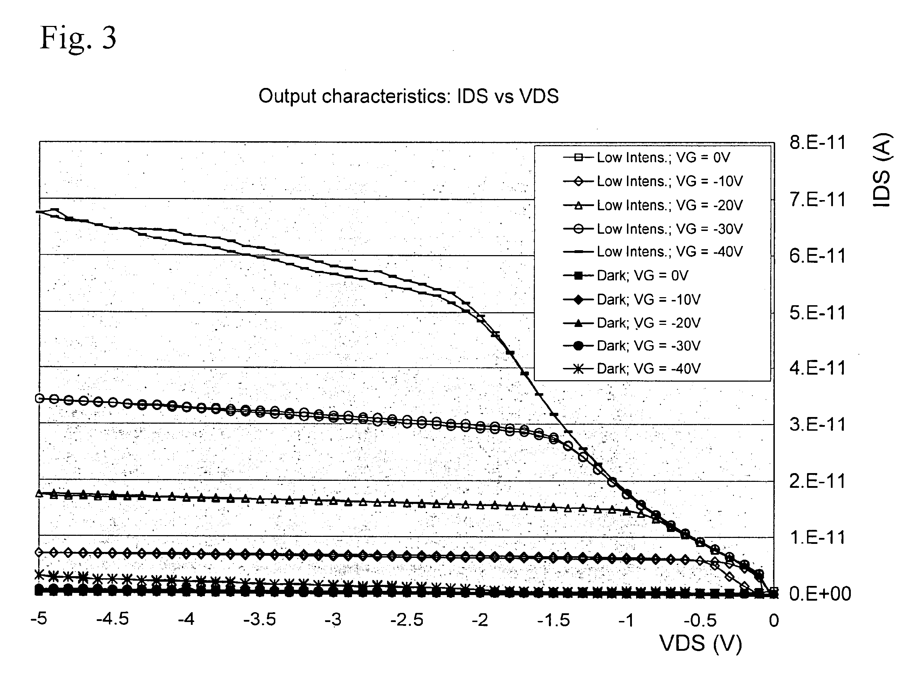

Figs. 3 to 7 show the properties of a photosensitive thin film transistor having the structure illustrated in Fig. 1 a in which the pattern of source and drain contacts was formed by first depositing a 30nm thick Cr adhesion layer onto a glass substrate and then thermally evaporating a 200nm thick layer of Ag onto the adhesion layer. Subsequently, the Ag layer was photolithographically processed to form the Ag source and drain contacts. The source and drain contacts were covered by a thin layer of Ag₂S, which is a photoconducting semiconductor and was formed by treating the silver contacts with H₂S gas.

The source/drain pattern was covered by a thin organic semiconductor layer 4 formed of poly(9,9-dioctylfluorene-co-bithiophene), to fill the gap between the source and the drain contacts, thus forming the transistor channel. Poly(9,9-dioctylfluorene-co-bithiophene) is a p-type, organic semiconductor material having low light absorption characteristics. The semiconductor layer 4 was covered by an insulating dielectric layer 5 of PVP, on top of which was deposited the gate electrode 6. The gate electrode was formed of PEDOT:PSS, which also has a high light transmissivity.

Fig. 3 displays the output characteristics (i.e. drain current (I_{DS}) vs. drain voltage (V_{DS})) of the photo-TFT for operation in the dark (filled symbols), and for illumination with a low-intensity light source of approximately 5000 Lux (open symbols). The output is displayed for gate voltages V_{G} of 0V, -10V, - 20V, -30V, and -40V. It is evident that the drain currents obtained for low-intensity illumination are substantially higher than the drain currents obtained for operation in the dark. Furthermore, the output curves for operation under low-intensity illumination clearly show two distinct regions of device operation: linear and saturation. After an initial linear increase of I_{DS} with increasing V_{DS}, the currents quickly reach saturation for the smaller gate voltages (V_{G} = -10V, -20V, -30V). In case of V_{G} = -40V, I_{DS} continues to rise approximately linearly, but with a slower rate as compared to the initial increase.

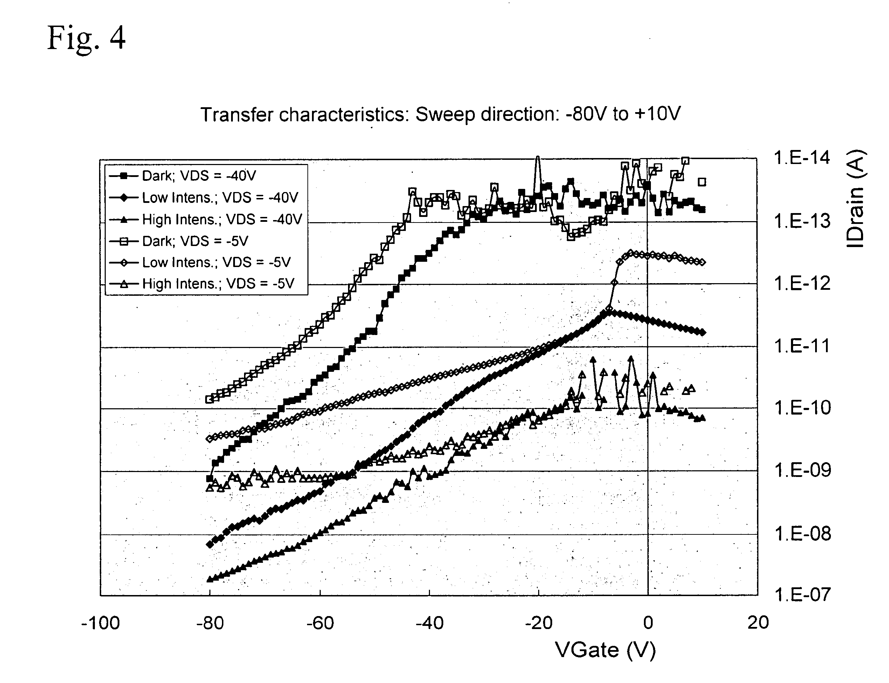

Fig. 4 displays the transfer characteristics (i.e. drain current (I_{DS}) vs. gate voltage (V_{G})) of the photo-TFT for operation in the dark (open and filled squares), for illumination with a low-intensity light source (open and filled rhombs), and for illumination with a high-intensity light source of approximately 50000 Lux (open and filled triangles). The transfer curves are displayed for device operation in the linear (open symbols) and the saturation (filled symbols) range (for drain voltages (V_{DS}) of -5V and -40V, respectively).

It is evident that the drain current I_{DS} through the device can be independently controlled by applying a gate voltage (V_{G}) and by illuminating the device.

In case of device operation in the dark, application of a negative V_{G} results in the accumulation of holes in the conduction channel and an increase of the drain current I_{DS}, in agreement with the p-type conduction in the organic semiconductor layer. The current levels in the "Off' state are very low, both in the linear and the saturation regime. The device turns on at around -40V gate voltage, i.e. the threshold voltage is strongly negative.

The fluctuations seen for gate voltages of -30V and under can most likely be attributed to noise. On this point, it is noted that currents of E-13 to E-14 A are shown.

In case of operation under low-intensity illumination, the current levels in the "Off' state are increased substantially, by approximately a factor of 10 for operation in the linear regime, and a factor of 100 for operation in the saturation regime. The device turns on above -10V gate voltage, which indicates a large shift of the threshold voltage towards positive gate voltages. For low gate voltages (V_{G} = -10V to -20V), the curves for operation in the linear and saturation regime are superimposed, which reflects the saturation of the drain current displayed in Fig. 3.

Finally, in the case of high-intensity illumination, the drain current levels are further increased by a factor of 10 - 100, as compared to operation under low-intensity illumination.

The fluctuations seen for gate voltages of -20V and under can most likely be attributed to noise due to electrical disturbance from the light source.

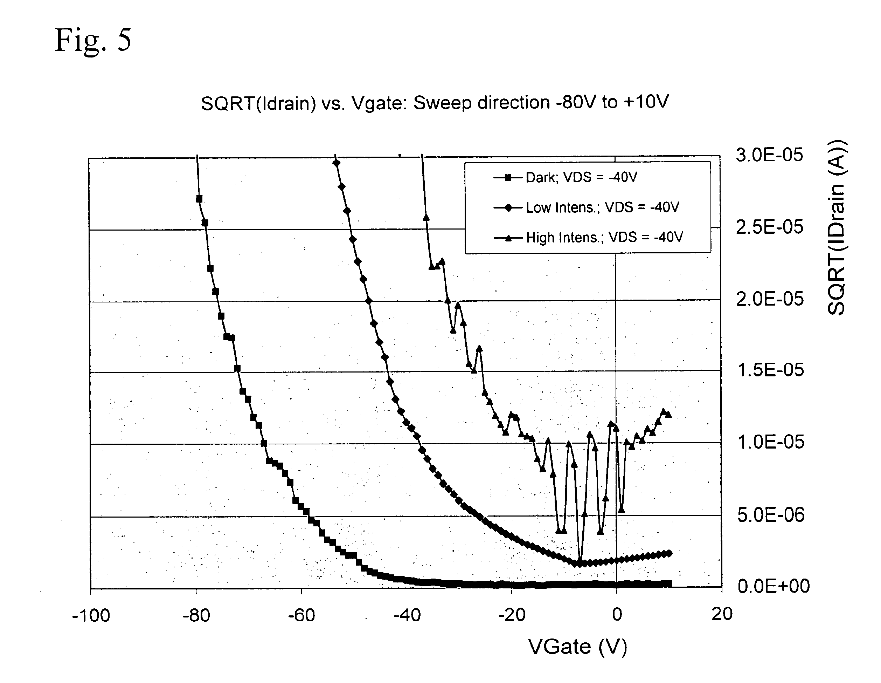

Fig. 5 displays plots of the square root of the drain currents (I_{DS}^{-½}) vs. gate voltage V_{G} for device operation in the saturation range for operation in the dark (filled squares), under low-intensity illumination (filled rhombs), and under high-intensity illumination (filled triangles). The curves clearly shift towards positive V_{G} upon illumination, which indicates a shift of the threshold voltage from negative values to around 0V.

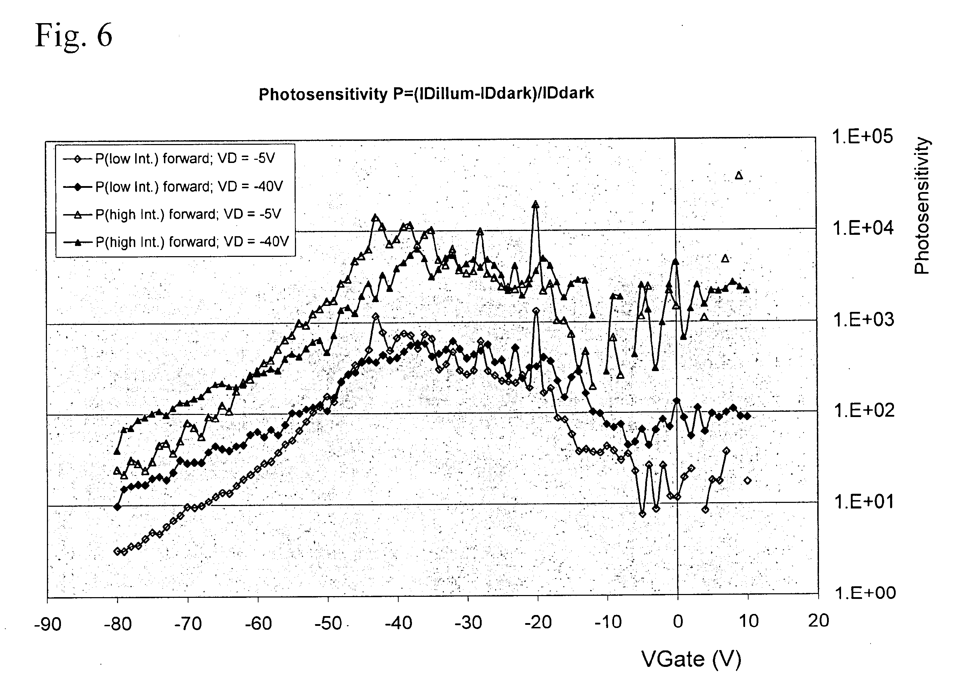

Fig. 6 displays plots of the photosensitivity (I_{DS}, illuminated - I_{DS}, dark)/I_{DS}, dark VS. the gate voltage V_{G} for low-intensity and high-intensity illumination (rhombs and triangles, respectively). As such, the data shown in Fig. 6 is derived from Fig. 4. The photosensitivity curves are displayed for device operation in the linear and the saturation range (for drain voltages (V_{DS}) of -5V (open symbols) and -40V (filled symbols), respectively). It is evident that the drain current increases with the illumination intensity. Furthermore, the highest photosensitivity is observed for intermediate gate voltages (V_{G} =-20V to -40V). Higher V_{G} results in higher absolute current levels but lower enhancement upon illumination, i.e. a reduced photosensitivity. Under optimal conditions, the photosensitivity reaches a value of approximately 10,000 (for high-intensity illumination of the photo-TFT operated in the linear regime).

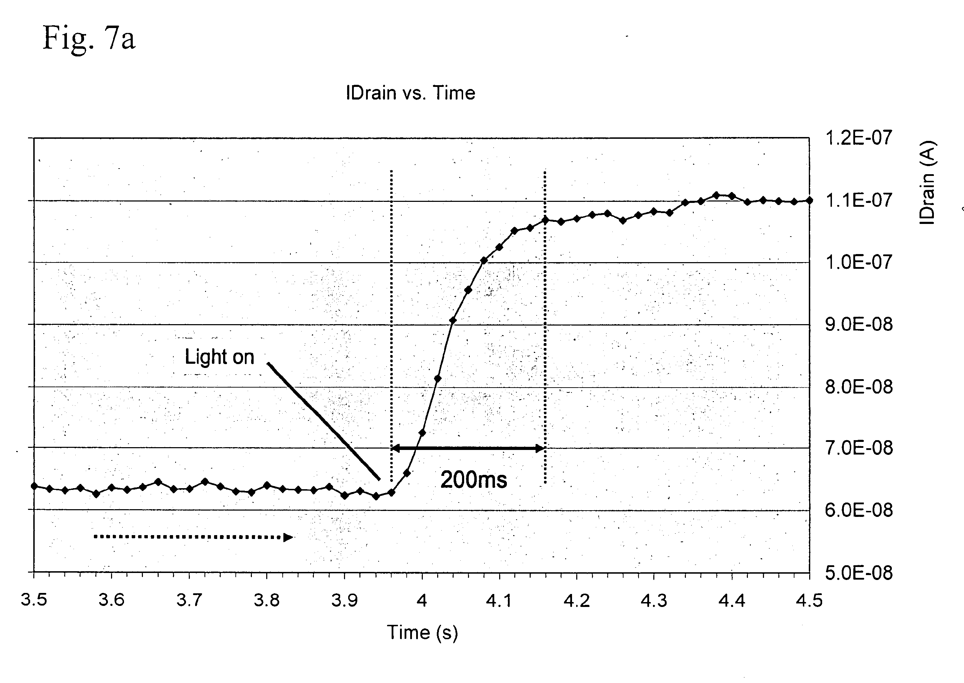

Fig. 7a displays the rise of the drain current I_{Ds} as a function of time after switching ON an additional light source (i.e. an increase of the illumination intensity from low-intensity to high-intensity). The response time is in the range of 200ms.

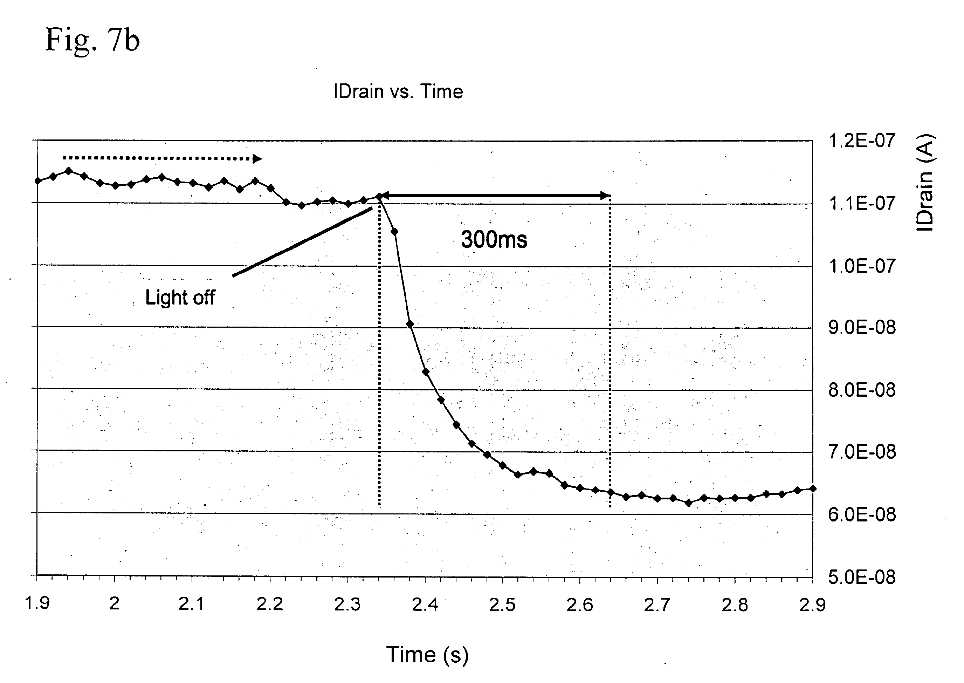

Fig. 7b displays the decay of the drain current I_{DS} as a function of time after switching OFF an additional light source (i.e. a decrease of the illumination intensity from high-intensity to low-intensity). The current decays within approximately 300ms.

In fact, the change between high- and low-intensity illumination was provided by switching a filament bulb ON and OFF. It is anticipated that the response time will have been affected by the time taken for the filament in the bulb to heat and cool, and hence emit light and stop emitting light. Accordingly, considerably faster response times can be expected than are illustrated by Fig. 7.

Irrespective of this, it is clear that the photosensitive transistor of the present application provides significantly reduced response times when compared with prior art photosensitive transistors. For example, the response times disclosed in US 6992322 are of the order 30-60 seconds.

One method of fabricating the structure shown in Fig. 1 a has been discussed. However, a variety of alternative methods may be used.

In a preferred method for fabricating a device having the structure shown in Fig. 1 a, source and drain electrodes are inkjet printed onto an insulating plastic substrate using a silver ink. After drying and annealing, a photoconductive silver sulphide (Ag₂S) layer is formed on the surface of the silver source/drain electrodes by exposure to H₂S gas with a duration of exposure of approximately 2 minutes. Preferably, the film thickness of the photoconductive coating is 300nm or less, and yet more preferably 100nm or less. Subsequently, the organic semiconductor layer is deposited by inkjet printing a solution (1% w/w) of poly(9,9-dioctylfluorene-co-bithiophene) in mesitylene onto the source/drain contacts. The dielectric layer is coated on top of the semiconductor layer by spin-coating, doctor blading, inkjet printing or screen printing an insulating polymer such as polyvinylphenol (PVP). Finally, the gate electrode is formed on top of the dielectric layer by inkjet printing the transparent conducting polymer PEDOT:PSS.

In this way, the photosensitive transistor can be fabricated at low temperatures and using flexible substrates. A particular advantage of inkjet printing the contacts is that they have a rougher surface than thermally evaporated contacts, irrespective of whether shadow masking or lithographic techniques are used. This greater surface roughness provides a larger surface area in contact with the photoconductive, semiconductor coating and therefore gives improved photosensitivity.

If desired, an anti-reflection coating may be provided over the phototransistor to enhance further the photosensitivity. In addition, colour filtering may be provided to control photosensitivity.

It should be noted that any suitable materials may be used in the fabrication of the photosensitive transistor. In particular, various materials suitable for use in substrate will be evident to those skilled in the art. These include various glasses and plastics, both rigid and flexible. Similarly, any suitable materials can be used for the source and drain contacts, the photoconductive coating, the semiconductor layer and the gate electrode.

The source and drain contacts comprise a conducting core covered by a thin layer of an inorganic [or metal-organic, or organic] photoconducting semiconductor material of a conduction type that is preferably opposite as compared to the conduction type of the semiconductor layer in the transistor channel. This assembly results in the formation of p-n junctions at the interfaces between the source/drain contacts and the semiconductor layer.

It is preferred to use silver for the source and drain contacts, since this can easily be deposited in solution or suspension using inkjet deposition techniques. Moreover, silver can easily be reacted with oxygen or sulphur to form the photoconductive coating. For example, the exposure of deposited contacts on the substrate to oxygen plasma (or even to atmosphere) will cause oxidation of the silver to form an Ag₂O photoconductive, semiconductor coating on the contacts. Similarly, the exposure of deposited contacts on the substrate to a sulphurous atmosphere will cause the formation of an Ag₂S photoconductive, semiconductor coating on the contacts. Copper, cadmium and lead are other preferred contact materials. It should be noted, however, that the contacts are not limited to these but may be formed from other metals, or even inorganic materials, as described above.

Similarly, the photoconductive material need not coat the whole of the contacts and need not be formed by chemical reaction of the contacts. Instead, it may be deposited on the contacts using other techniques including, for example, a wet process using (NH₄)₂S, inkjet film fabrication, and dry film fabrication.

It is preferred to use an organic material for the semiconductor layer 4, since these can also be deposited in solution using inkjet deposition techniques. Preferred organic semiconductor materials include poly(9,9-dioctylfluorene-co-bithiophene), polyarylamines, and polythiophenes (PQT). However, other organic semiconductor materials could also be used. There is no particular requirement for the semiconductor material to be photoconductive or otherwise. Thus, the semiconductor layer is preferably made of a Π-conjugated material [p-type or n-type; polymeric, oligomeric or small molecule; organic or inorganic nanoparticles; soluble, soluble as a precursor, or vapour phase deposited].

In general, it is preferred to use a p-type material for the semiconductor material 4 and an n-type material for the photoconductive, semiconductor coating material 3. However, the conductivity types may be swapped. Either way, a p-n junction is formed at the interface between the source and drain electrodes and the semiconductor layer.

As noted above, it is preferred that the semiconductor layer and the photoconductive semiconductor coating have opposite conductivity type. This has the advantage that only a thin photoconductive, semiconductor coating is required to provide the device with strong optical properties. The optical sensitivity is further improved by using a transparent or substantially transparent semiconductor layer and a highly light absorbing photoconductive semiconductor coating.

The insulator layer is preferentially made of a solution-processable insulating material such as an organic polymer [i.e. polyvinylphenol, PVP], or 3D-crosslinkable organic oligomers [i.e. Cyclotene], or organic-inorganic hybrid materials [i.e. ORMOCERs]

ITO would be suitable for use as the gate electrode in the structure of Fig. 1 a since it is optically transmissive. However, PEDOT is preferred since it is easily deposited in a PEDOT:PSS suspension by inkjet printing. Of course, other conductive materials suitable for use as the gate electrode will be known to those skilled in the art.

In the foregoing specific embodiments, a photo-TFT is provided with a p-type semiconductor layer and an n-type photoconductive semiconductor coating.

With reference to Fig. 1 b, which is a schematic diagram illustrating a bottom-gate configuration of a photo-TFT structure, there will now be described an embodiment in accordance with the present invention in which a photo-TFT is provided with an n-type semiconductor layer and a p-type photoconductive semiconductor coating.

The structure comprises an insulating substrate 1 (e.g. a glass substrate or a PET foil) onto which the gate electrode 6 has been deposited (e.g. gold (Au) evaporated through a shadow mask). The gate electrode 6 and the surrounding substrate areas are covered by an insulating dielectric layer 5 (e.g. 600nm of polyvinylphenol, deposited by spin-coating). A pattern of separate, electrically conducting source and drain contacts 2 is defined on top of the dielectric layer 5, each overlapping with an opposite edge of the underlying gate electrode 6. These source and drain contacts may be made of acid-doped polyaniline (e.g. the polyaniline-camphorsulfonic acid complex PANI-CSA). PANI-CSA is a p-type conducting polymer, i.e. it combines the functionalities of the metallic source and drain contacts 2 and the thin layer of the photoconductive semiconductor 3 on top of the source and drain contacts (however, due to the high doping level, the conductivity within the PANI-CSA does not strongly depend on the illumination). PANI-CSA is soluble in organic solvents (e.g. m-cresol, chloroform, N-methyl pyrrolidone (NMP), etc). The source and drain contacts can therefore be deposited by inkjet printing onto the dielectric layer.

The PANI-CSA source/drain pattern on top of the PVP dielectric layer 5 is covered by a thin organic semiconductor layer 4, which fills the gap between the source and the drain contacts 2, thus forming the transistor channel. The organic semiconductor displays n-type conductivity. Suitable materials for the n-type semiconductor layer include evaporated layers (approx. 40nm) of fullerene (C60) or spin-coated layers (approx. 40nm) of PCBM. Alternatively, the n-type semiconductor may be inorganic, such as a layer of magnetron-sputtered zinc oxide (ZnO).

In summary, the phototransistor of the present invention provides a highly light sensitive phototransistor, with low off-currents even under high-intensity illumination, high gain and quick response times. In particular, the transistor exhibits large photosensitivity indicated by sizeable changes in the sourcedrain current, achieving an increase by a factor of 10²- 10³ even at low levels of illumination (approx. 5000 Lux). The phototransistor is also flexible in that it can be controlled as a function of both the degree of illumination and the gate voltage. Moreover, the phototransistor is simple and cheap to manufacture and can be fabricated at low temperatures using inkjet or other printing and deposition techniques.

Several combinations of materials for the conducting core of the source/drain electrodes, the semiconductor layer covering the source/drain electrodes, and the semiconducting material forming the transistor channel are disclosed. Several processes for forming the semiconductor layer covering the source/drain electrodes, as well as for forming other layers, are disclosed. These are non-limiting examples. In particular, any one or a combination of the following techniques may be used in the formation of a photo-TFT in accordance with the present invention: inkjet deposition, contact printing, screen printing, lithography, sputtering, vapour deposition, and shadow masking.

The phototransistor of the present invention is particularly suitable for use in flat panel image sensors and fingerprint sensors, where the short response times are particularly beneficial.

The term "coating" in this specification should not be construed in a limiting way and includes any suitable layer, which need not be a coating layer.

The foregoing description has been given by way of example only. However, it will be appreciated by a person skilled in the art that modifications can be made within the scope of the present invention.

## Claims

1. A photosensing transistor comprising:
a source electrode;
a drain electrode;
a semiconductor layer of a first semiconductor material, which forms a channel of the transistor;
a gate electrode; and
an insulating layer between the gate electrode and the semiconductor layer,
wherein a second semiconductor material is disposed between and in electrical connection with the semiconductor layer and at least one of the source electrode and the drain electrode, the second semiconductor material being photoconductive.

2. A photosensing transistor according to claim 1, wherein the first and second semiconductor materials are of opposite conductivity types, wherein a p-n junction is formed at each interface between the first and second semiconductor materials.

3. A photosensing transistor according to claim 2, wherein the first semiconductor material is p-type and the second semiconductor material is n-type.

4. A photosensing transistor according to any one of the preceding claims, wherein the second semiconductor material is formed between and in electrical connection with the first semiconductor layer and the source electrode.

5. A photosensing transistor according to any one of the preceding claims, wherein the second semiconductor material is formed between and in electrical connection with the first semiconductor layer and both the source electrode and the drain electrode.

6. A photosensing transistor according to any one of the preceding claims, wherein a thickness of the second semiconductor material is 100nm or less.

7. A photosensing transistor according to any of the preceding claims, wherein the first semiconductor material has a field effect mobility of 10⁻³ cm²/Vs or greater

8. A photosensing transistor according to any of the preceding claims, wherein the second semiconductor material is inorganic.

9. A photosensing transistor according to any one of the preceding claims, wherein the second semiconductor material is formed by chemical reaction of the source or drain electrode.

10. A photosensing transistor according to claim 9, wherein the second semiconductor material is formed from a reaction of the source or conductor with a Group 16 element of the periodic table.

11. A photosensing transistor according to any one of claims 1 to 8, wherein the second semiconductor material is formed by one of a wet process using (NH₄)₂S, inkjet film fabrication, or dry film fabrication.

12. A photosensing transistor according to any one of the preceding claims, wherein the source and drain electrodes are formed with a Group 11 or a Group 12 element of the periodic table.

13. A photosensing transistor according to any one of the preceding claims, wherein the gate electrode has an optical transmission across the visible wavelength range of more than 50%.

14. A photosensing transistor according to any one of the preceding claims, wherein the insulating layer has an optical transmission across the visible wavelength range of more than 80%.

15. A photosensing transistor according to any one of the preceding claims, wherein the first semiconductor material has a light absorption coefficient of 10⁴cm⁻¹ or less for at least a portion of the visible wavelength range.

16. A photosensing transistor according to any one of the preceding claims, wherein the second semiconductor material has a light absorption coefficient of more than 10⁴cm⁻¹ across the visible wavelength range.

17. A photosensing transistor according to any one of the preceding claims, wherein at least one of the source and drain electrodes is formed of the second semiconductor material.

18. A photosensing transistor according to any one of the preceding claims, further comprising a colour filter.

19. A photosensing transistor according to claim 18, wherein the colour filter is formed by providing a colorant in at least one of the gate electrode and the insulating layer.

20. An electrical device comprising a photosensing transistor according to any one of the preceding claims.
